# EUROPÄISCHE PATENTSCHRIFT

(11) **EP 1 111 974 B1**
(45) Veröffentlichungstag und Bekanntmachung des Hinweises auf die Patenterteilung: **31.10.2007**
(21) Anmeldenummer: 00127521.3
(22) Anmeldetag: 15.12.2000
(51) Int. Cl.: H05K 3/34

(54) **Verfahren zur Herstellung einer Lötverbindung**
Process for manufacturing a solder connection
Procédé de fabrication d'une connexion à soudage

(30) Priorität: 24.12.1999 DE 19963108
(43) Veröffentlichungstag der Anmeldung: 27.06.2001
(73) Patentinhaber: Grundig Multimedia B.V., 1083HJ Amsterdam (NL)
(72) Erfinder: Schneidzig, Peter, 90471 Nürnberg (DE)
(74) Vertreter: Pröll, Jürgen

(56) Entgegenhaltungen:
- EP-A- 0 594 408
- CH-A- 375 051
- DE-A- 2 657 313
- US-A- 3 500 538
- US-A- 4 477 970
- PATENT ABSTRACTS OF JAPAN vol. 1999, no. 14, 22. Dezember 1999 (1999-12-22) -& JP 11 251733 A (FUJI XEROX CO LTD), 17. September 1999 (1999-09-17)
- PATENT ABSTRACTS OF JAPAN vol. 1999, no. 03, 31. März 1999 (1999-03-31) -& JP 10 335775 A (FUJI ELECTRIC CO LTD), 18. Dezember 1998 (1998-12-18)
- PATENT ABSTRACTS OF JAPAN vol. 017, no. 264 (E-1370), 24. Mai 1993 (1993-05-24) -& JP 05 007077 A (MATSUSHITA ELECTRIC WORKS LTD), 14. Januar 1993 (1993-01-14)
- PATENT ABSTRACTS OF JAPAN vol. 013, no. 230 (E-764), 26. Mai 1989 (1989-05-26) -& JP 01 037073 A (SONY CORP), 7. Februar 1989 (1989-02-07)

## Beschreibung

Die Erfindung betrifft ein Verfahren zur Herstellung einer Lötverbindung eines Anschlußelements mit einer auf einer Platine vorgesehenen Kontaktstelle. Sie betrifft ferner eine Schaltung.

Nach dem Stand der Technik wird eine Lötverbindung von Anschlußelementen mit Kontaktstellen einer Platine üblicherweise im Wellenlötverfahren hergestellt. Dabei wird eine Unterseite der Platine mit schmelzflüssigem Lot beaufschlagt. Das schmelzflüssige Lot haftet an den Kontaktstellen und den diese Kontaktstellen durchgreifenden Anschlußelementen. Die Anschlußelemente werden nach der Erstarrung des Lots elektrisch leitend mit den ersten Kontaktstellen fest verbunden. - Das Eigengewicht des Bauelements wird über die so hergestellte Lötverbindung auf die Platine abgetragen. Im Laufe der Zeit kommt es, bedingt durch Erwärmung oder Erschütterung, spannungsbedingt im Lot zu Veränderungen der Kristallstruktur. Das kann zum Bruch der Lötverbindung führen. Man bezeichnet eine derart gebrochene Lötverbindung auch als "kalte Lötstelle".

Um diesem Nachteil entgegenzuwirken ist man dazu übergegangen, eine Niete im Bereich eines die Kontaktstelle durchgreifenden Durchbruchs vorzusehen. Wegen der für das Lot günstigeren Benetzungseigenschaften des Nietenmaterials wird hier das Lot durch Kapillarkräfte in einen zwischen der Niete und dem Anschlußelement gebildeten Ringspalt gezogen. Die sich ergebende Lötverbindung ist haltbarer. Das Vorsehen einer Niete ist jedoch insbesondere bei stark miniaturisierten Schaltungen sowie Schaltungen mit einer Vielzahl von ersten Kontaktstellen zeit- und kostenaufwendig.

Des weiteren ist es bekannt, die Innenwand des Durchbruchs mit Lot zu beschichten. Auch dieses Verfahren führt zu einer haltbareren Lötverbindung. Gleichwohl ist der damit verbundene Kosten- und Zeitaufwand ebenfalls erheblich.

Ferner sind nach dem Stand der Technik Platinen bekannt, welche beidseitig mit einer Kupferschicht versehen sind. Auf der unteren Seite dient die Kupferschicht zur Herstellung elektrischer Verbindungswege. Die Durchbrüche sind hier unmittelbar von den Kontaktelementen umgeben, selbst aber nicht leitend ummantelt. Auf der Oberseite dient die Kupferschicht üblicherweise nicht zur Herstellung von elektrischen Verbindungswegen, sondern zur Abschirmung. Um die Gefahr einer Fehlkontaktierung zu minimieren, weist die Kupferschicht im Bereich der Durchbrüche Aussparungen auf. Im übrigen ist die auf der Oberseite vorgesehene Kupferschicht mit einem elektrisch isolierenden Lötstoplack überdeckt.

Aus JP 11 04 6057 A ist ein Verfahren zur Herstellung einer Lötverbindung eines Anschlusselements mit einer auf einer Platine vorgesehenen Kontaktstelle mit folgenden Schritten bekannt:
- Vorsehen einer ersten Kontaktstelle auf der Unterseite der Platine und einer zweiten Kontaktstelle in gegenüberliegender Anordnung auf der Oberseite der Platine,
- Durchführen des Anschlusselements durch einen die erste und die zweite Kontaktstelle durchgreifenden Durchbruch, so dass das freie Ende des Anschlusselements über eine durch die erste Kontaktstelle beschriebene Ebene hervorsteht und zwischen der Wand des Durchbruchs und dem Anschlusselement ein Ringspalt gebildet ist und
- Aufbringen eines schmelzflüssigen Lots auf die erste Kontaktstelle und das freie Ende des Anschlusselements, so dass das Lot in den Ringspalt eindringt und entlang des Anschlusselements zur zweiten Kontaktstelle (7) fließt und eine Lötverbindung zwischen der ersten und der zweiten (7) Kontaktstelle und dem Anschlusselement (9) gebildet wird.

Aus EP 0 367 076 A ist ein Verfahren zur Durchkontaktierung einer beidseitig kaschierten Leiterplatte bekannt. Hierbei werden über Öffnungen in der Leiterplatte Bauelemente durchgeführt und auf der Unterseite verlötet.

Aus DE 3 231 056 A ist ein Verfahren zum Aufbringen von unbedrahteten Bauelementen auf Leiterplatten bekannt. Hierbei werden Lötflächen an den Stellen auf der Bauelementseite der Leiterplatte erzeugt, an denen nach dem Aufbringen der unbedrahteten Bauelemente, deren Anschlüsse aufliegen.

Auf der dazu gegenüberliegenden Stelle der Lötseite der Leiterplatte werden ebenfalls Lötflächen erzeugt. Die die Lötflächen verbindenden Bohrungen sind in die Leiterplatte eingearbeitet, wobei diese Bohrungen anschließend metallisiert werden, wobei zu beachten ist, dass die Bauelemente die Bohrungen beim Aufbringen nicht vollständig bedecken. Anschließend werden die aufgebrachten Bauelemente in einem maschinellen Lötverfahren gelötet.

Aufgabe der Erfindung ist es, die Nachteile nach dem Stand der Technik zu beseitigen. Es soll insbesondere ein Verfahren angegeben werden, mit dem auf möglichst einfache und kostengünstige Weise eine haltbare Lötverbindung hergestellt wird.
Diese Aufgabe wird durch die Merkmale der Ansprüche 1 und 8 gelöst. Zweckmäßige Ausgestaltungen ergeben sich aus den Merkmalen der Ansprüche 2 bis 7.

Nach Maßgabe der Erfindung ist ein Verfahren zur Herstellung einer Lötverbindung eines Anschlusselements mit einer auf einer Platine vorgesehenen Kontaktstelle mit folgenden Schritten vorgesehen:
Aus US-A-3,500,538 ist ein Verfahren zur Herstellung eines Drahtes, der mit einer Halterung verlötet werden soll, bekannt. Am Draht selbst sind mehrere Längsnuten entlang des Umfangs des Drahtes angeordnet. Diese Nuten dienen zur Erzeugung eines Kapillareffektes um flüssiges Lot durch die Öffnung einer Leiterplatte am Draht entlang zu ziehen.

Aufgabe der Erfindung ist es, die Nachteile nach dem Stand der Technik zu beseitigen. Es soll insbesondere ein Verfahren angegeben werden, mit dem auf möglichst einfache und kostengünstige Weise eine haltbare Lötverbindung hergestellt wird.
Diese Aufgabe wird durch die Merkmale der Ansprüche 1 und 7 gelöst. Zweckmäßige Ausgestaltungen ergeben sich aus den Merkmalen der Ansprüche 2 bis 6.
a) Vorsehen einer ersten Kontaktstelle auf der Unterseite der Platine und einer zweiten Kontaktstelle in gegenüberliegender Anordnung auf der Oberseite der Platine,
b) Durchführen des Anschlußelements durch einen die erste und die zweite Kontaktstelle durchgreifenden Durchbruch, so daß das freie Ende des Anschlußelements über eine durch die erste Kontaktstelle beschriebene Ebene hervorsteht und zwischen der Wand des Durchbruchs und dem Anschlußelement ein Ringspalt gebildet ist, und
c) Aufbringen eines schmelzflüssigen Lots auf die erste Kontaktstelle und das freie Ende des Anschlußelements, so daß das Lot in den Ringspalt eindringt und entlang des Anschlußelements zur zweiten Kontaktstelle fließt, und eine Lötverbindung zwischen der ersten und der zweiten Kontaktstelle und dem Anschlußelement gebildet wird.

Mit dem vorgeschlagenen Verfahren kann auf einfache und kostengünstige Weise eine besonders stabile Lötverbindung hergestellt werden. Die Lötverbindung kann unter Verwendung des herkömmlichen Wellenlötverfahrens hergestellt werden. Zu ihrer Realisierung ist es lediglich erforderlich, die Struktur einer an sich bekannten auf der Oberseite von Platinen vorgesehenen Kupfer- und Lötstoplackschicht zu ändern.

Vorteilhafterweise wird die Spaltbreite des Ringspalts so dimensioniert, daß das Lot durch Kapillarkräfte von der ersten bis zur zweiten Kontaktstelle bewegt wird. Es kann in diesem Fall auf gesonderte Mittel zur Bewegung des Lots von der ersten bis zur zweiten Kontaktstelle verzichtet werden. Bei solchen gesonderten Mitteln kann es sich z.B. um Mittel zur Erzeugung eines auf den Ringspalt wirkenden Unterdrucks handeln.

Nach einem weiteren Ausgestaltungsmerkmal ist vorgesehen, daß vor der Herstellung der Lötverbindung auf die erste und/oder zweite Kontaktstelle eine aus Lot hergestellte Schicht aufgebracht wird. Eine solche Schicht schmilzt besonders leicht bei Kontakt mit dem schmelzflüssigen Lot. Sie kann auf die erste und/oder zweite Kontaktstelle gewalzt oder gedruckt werden.

Nach einer weiteren Ausgestaltung kann mindestens ein weiterer die erste mit der zweiten Kontaktstelle verbindender Durchbruch vorgesehen sein. Der Durchmesser des weiteren Durchbruchs ist zweckmäßigerweise so dimensioniert, daß das Lot durch Kapillarkräfte von der ersten zur zweiten Kontaktstelle bewegt wird. Der weitere Durchbruch kann im Randbereich der Kontaktstellen vorgesehen sein. Im Falle des Vorsehens mehrerer weiterer Durchbrüche sind diese vorteilhafterweise kranzartig um den Umfang der Kontaktstellen angeordnet. Die vorgeschlagene Ausgestaltung trägt zu einer besonders schnellen und sicheren Ausbildung der die erste und zweite Kontaktstelle verbindenden Lötbrücke bei.

Desweiteren hat es sich als vorteilhaft erwiesen, ein mit dem Anschlußelement verbundenes Bauelement in der Nähe der zweiten Kontaktstelle derart anzuordnen, daß das Lot das Bauelement mit der zweiten Kontaktstelle verbindet. In diesem Fall wird das Eigengewicht des Bauelements unmittelbar auf die auf der Oberseite der Platine angeordnete zweite Kontaktstelle abgetragen. Damit wird besonders effektiv einem Bruch der Lötstelle entgegengewirkt. Um die vorgenannte Lötverbindung möglichst zuverlässig herzustellen, ist es zweckmäßig, das Bauelement vor der Montage zumindest abschnittsweise mit dem Lot zu beschichten.

Nachfolgend werden anhand der Zeichnungen Ausführungsbeispiele der Erfindung näher erläutert. Es zeigen:
- Fig.1: einen schematischen Querschnitt eines ersten Ausführungsbeispiels,
- Fig.2: das Ausführungsbeispiel nach Fig.1 im verlöteten Zustand,
- Fig.3: eine Querschnittsansicht eines zweiten Ausführungsbeispiels im verlöteten Zustand und
- Fig.4: eine Querschnittsansicht eines dritten Ausführungsbeispiels im verlöteten Zustand.

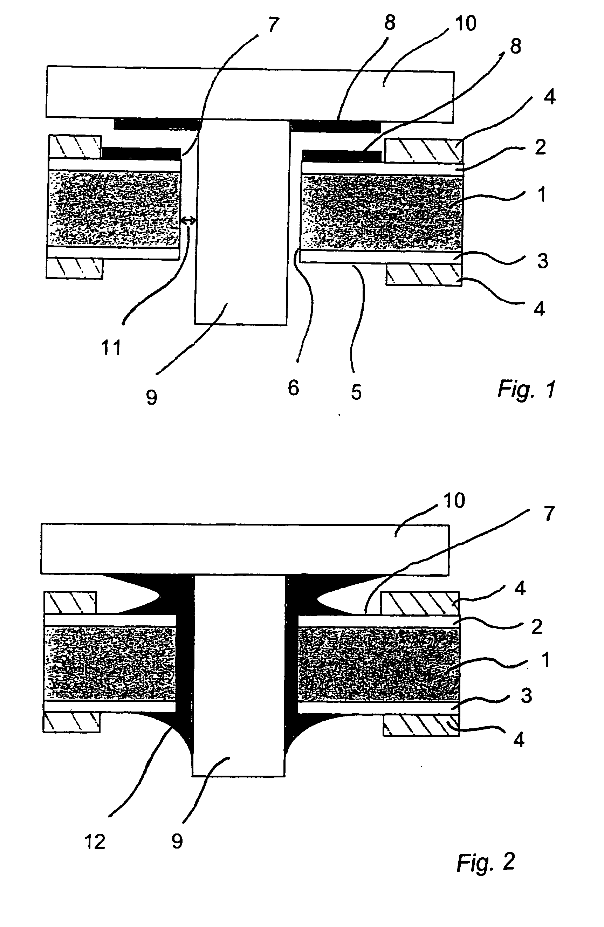

In den Fig.1 bis 4 ist mit 1 eine Platine bezeichnet auf deren Oberseite eine erste Kupferschicht 2 und auf deren Unterseite eine zweite Kupferschicht 3 aufgebracht sind. Die erste Kupferschicht 2 ist mit einem elektrisch isolierenden Lötstoplack 4 teilweise überdeckt. Desgleichen ist auch die zweite Kupferschicht teilweise mit dem Lötstoplack 4 überdeckt. Eine erste Kontaktstelle 5 ist kreisförmig ausgebildet. Sie wird randlich durch den Lötstoplack 4 begrenzt. Die erste Kontaktstelle 5 weist einen zentralen Durchbruch 6 auf. In ähnlicher Weise ist auf der Oberseite der Platine 1 eine zweite Kontaktstelle 7 gebildet, die ebenfalls kreisförmig durch den Lötstoplack 4 begrenzt ist. Auch die zweite Kontaktstelle 7 weist den zentralen Durchbruch 6 auf. Die zweite Kontaktstelle 7 ist hier zusätzlich mit einem Lot 8 beschichtet. Das Lot 8 kann z.B. durch ein Druckverfahren aufgebracht werden.

Mit 9 ist ein Anschlußelement eines Bauelements 10 bezeichnet. Das Anschlußelement 9 durchgreift den Durchbruch 6. Sein freies Ende ragt über die durch die erste Kontaktstelle 5 gebildete Ebene an der Unterseite der Platine 1 hervor. Zwischen dem Anschlußelement 9 und der Innenseite des Durchbruchs 6 ist ein Ringspalt 11 gebildet.

In Fig.2 ist das Ausführungsbeispiel gemäß Fig.1 im verlöteten Zustand gezeigt. Z.B. im Wellenlötverfahren wird das freie Ende des Anschlußelements 9 mit schmelzflüssigem Lot 12 beaufschlagt. Das schmelzflüssige Lot 12 fließt durch die Wirkung von Kapillarkräften in den Ringspalt 11 und kommt schließlich mit dem festen Lot 8 in Kontakt, welches auf der zweiten Kontaktstelle 7 aufgebracht ist. Das Lot 8 schmilzt infolge des Kontakts mit dem schmelzflüssigen Lot 12. Es kann aber auch durch unmittelbaren Kontakt mit dem durch das schmelzflüssige Lot 12 erhitzten Anschlußelement 9 schmelzen, dann von oben in den Ringspalt 11 eindringen und sich mit dem darin aufsteigenden Lot 12 vereinigen. Es bildet sich auf der zweiten Kontaktstelle 7 eine Lotmeniskus, der wiederum in Kontakt mit einer am Bauelement 10 vorgesehen Schicht des Lots 8 kommt. Dadurch wird auch diese Schicht geschmolzen. Es bildet sich insgesamt eine komplexe Lötverbindung zwischen der ersten Kontaktstelle 5, der zweiten Kontaktstelle 7, dem Anschlußelement 9 und dem Bauelement 10 aus. Wie aus Fig.2 deutlich erkennbar ist, wird das Eigengewicht des Bauelements 10 unmittelbar auf die zweite Kontaktstelle 7 abgetragen. Die so hergestellte Lötverbindung ist besonders dauerhaft. Das Risiko eines Bruchs einer solchen Lötverbindung ist minimal.

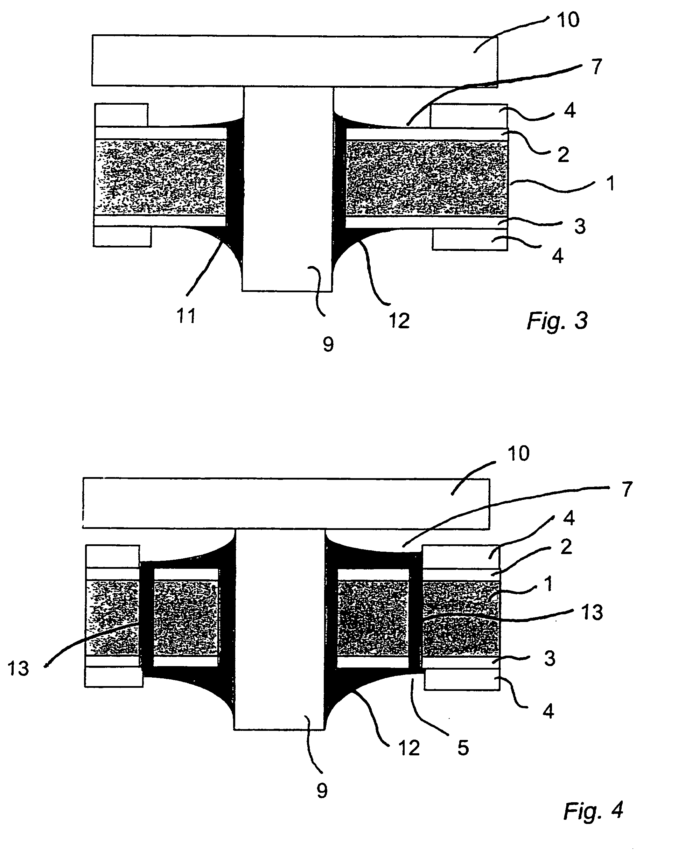

In Fig.3 ist eine sich ausbildende Lötverbindung gezeigt, bei der auf das zusätzliche Aufbringen eines Lots 8 auf die zweite Kontaktstelle 7 sowie das Bauelement 10 verzichtet worden ist. Auch in diesem Fall wird das schmelzflüssige Lot durch Kapillarkräfte in den Ringspalt 11 gezogen und gelangt bis zur zweiten Kontaktstelle 7. Auch hier wird das Eigengewicht des Bauelements 10 durch die gebildete Lötverbindung unmittelbar auf die zweite Kontaktstelle 7 abgetragen.

Bei dem in Fig.4 im schematischen Querschnitt gezeigten Ausführungsbeispiel sind weitere Durchbrüche 13 vorgesehen, welche die Platine 1 sowie die erste 5 und die zweite Kontaktstelle 7 randlich durchgreifen. Beim Aufbringen des schmelzflüssigen Lots 12 auf die erste Kontaktstelle 5 wird dieses sowohl durch den Ringspalt 11 als auch durch die weiteren Durchbrüche 13 durch Kapillarkräfte bis auf die zweite Kontaktstelle 7 gezogen. Es bildet sich ein Lötminiskus im Bereich der zweiten Kontaktstelle 7 aus. Die so hergestellte Lötstelle ist besonders stabil.

Das Verfahren kann insbesondere dann besonders effektiv durchgeführt werden, wenn der Durchmesser der weiteren Durchbrüche 13 sowie der Spaltabstand des Ringspalts 11 so gewählt sind, daß mittels Kapillarkräften das schmelzflüssige Lot 12 bis zur Oberfläche der zweiten Kontaktstelle 7 bewegt wird. Um die Bewegung des schmelzflüssigen Lots 12 zu unterstützen ist es aber auch möglich, die Oberseite der Platine 1 mit einem Unterdruck zu beaufschlagen.

### Bezugszeichenliste

- 1: Platine
- 2: erste Kupferschicht
- 3: zweite Kupferschicht
- 4: Lötstoplack
- 5: erste Kontaktstelle
- 6: Durchbruch
- 7: zweite Kontaktstelle
- 8: Lötschicht
- 9: Anschlußelement
- 10: Bauelement
- 11: Ringspalt
- 12: schmelzflüssiges Lot
- 13: weiterer Durchbruch

## Patentansprüche

1. Verfahren zur Herstellung einer Lötverbindung eines Anschlusselements (9) mit einer auf einer Platine (1) vorgesehenen Kontaktstelle (5,7) mit folgenden Schritten:
- Vorsehen einer ersten Kontaktstelle (5) auf der Unterseite der Platine (1) und einer zweiten Kontaktstelle (7) in gegenüberliegender Anordnung auf der Oberseite der Platine (1),
- Durchführung eines Anschlusselements (9) durch einen die erste (5) und die zweite Kontaktstelle (7) durchgreifenden Durchbruch (6), so dass das freie Ende des Anschlusselements (9) über eine durch die erste Kontaktstelle (5) beschriebene Ebene hervorsteht und zwischen der Wand des Durchbruches (6) und dem Anschlusselement (9) ein Ringspalt (11) gebildet ist und
- Aufbringen eines schmelzflüssigen Lots (12) auf die erste Kontaktstelle (5) und das freie Ende des Anschlusselements (9), so dass das Lot (12) in den Ringspalt (11) eindringt und entlang des Anschlusselements (9) zur zweiten Kontaktstelle (7) fließt, und eine Lötverbindung zwischen der ersten (5) und der zweiten Kontaktstelle (7) und dem Anschlusselement (9) gebildet wird
**dadurch gekennzeichnet, dass**
ein mit dem Anschlusselement (9) verbundenes Bauelement (10) in der Nähe der zweiten Kontaktstelle (7) derart angeordnet wird, dass das Lot (12) das Bauelement (10) mit der zweiten Kontaktstelle (7) verbindet.

2. Verfahren nach Anspruch 1, wobei eine Spaltbreite des Ringspalts (11) so dimensioniert wird, dass das Lot (12) durch Kapillarkräfte von der ersten (5) zur zweiten Kontaktstelle (7) bewegt wird.

3. Verfahren nach einem der vorhergehenden Ansprüche, wobei vor der Herstellung der Lötverbindung auf die erste (5) und/oder zweite Kontaktstelle (7) eine aus Lot (8) hergestellte Schicht aufgebracht wird.

4. Verfahren nach einem der vorhergehenden Ansprüche, wobei mindestens ein weiterer die erste (5) mit der zweiten Kontaktstelle (7) verbindender Durchbruch (13) vorgesehen ist.

5. Verfahren nach einem der vorhergehenden Ansprüche, wobei der Durchmesser des weiteren Durchbruchs (13) so dimensioniert ist, dass das Lot (12) durch Kapillarkräfte von der ersten (5) zur zweiten Kontaktstelle (7) bewegt wird.

6. Verfahren nach einem der vorhergehenden Ansprüche, wobei der weitere Durchbruch (13) im Randbereich der Kontaktstellen (5, 7) vorgesehen ist.

7. Schaltung mit einer nach einem der Ansprüche 1 bis 6 hergestellten Lötverbindung, eines Anschlusselements (9) mit einer auf der Platine (1) vorgesehenen Kontaktstelle (5,7) mit folgenden Merkmalen:
- einer ersten Kontaktstelle (5) auf der Unterseite der Platine (1) und einer zweiten Kontaktstelle (7) in gegenüberliegender Anordnung auf der Oberseite der Platine (1),
- einem Anschlusselement (9) das durch einen die erste (5) und die zweite Kontaktstelle (7) durchgreifenden Durchbruch (6) durchgeführt ist, so dass das freie Ende des Anschlusselements (9) über eine durch die erste Kontaktstelle (5) beschriebene Ebene hervorsteht und zwischen der Wand des Durchbruches (6) und dem Anschlusselement (9) ein Ringspalt (11) gebildet ist, wobei
- die Lötverbindung zwischen der ersten (5) und der zweiten Kontaktstelle (7) und dem Anschlusselement (9) durch Aufbringen eines schmelzflüssigen Lots (12) auf die erste Kontaktstelle (5) und das freie Ende des Anschlusselements (9), so dass das Lot (12) in den Ringspalt (11) eindringt und entlang des Anschlusselements (9) zur zweiten Kontaktstelle (7) fließt, gebildet wird
**dadurch gekennzeichnet, dass**
ein mit dem Anschlusselement (9) verbundenes Bauelement (10) in der Nähe der zweiten Kontaktstelle (7) derart angeordnet ist, dass das Lot (12) das Bauelement (10) mit der zweiten Kontaktstelle (7) verbindet.

## Claims

1. Method for producing a soldered joint of a terminal element (9) with a contact point (5, 7) provided on a circuit board (1) comprising the following steps:
- providing a first contact point (5) on the lower face of the circuit board (1) and a second contact point (7) in opposing arrangement on the upper face of the circuit board (1),
- passing a terminal element (9) through an opening (6) penetrating the first (5) and the second contact point (7), so that the free end of the terminal element (9) projects beyond a plane described by the first contact point (5) and an annular gap (11) is formed between the wall of the opening (6) and the terminal element (9) and
- applying molten solder (12) onto the first contact point (5) and the free end of the terminal element (9) so that the solder (12) penetrates into the annular gap (11) and flows along the terminal element (9) to the second contact point (7) and a soldered joint is formed between the first (5) and the second contact point (7) and the terminal element (9)
**characterised in that**
a component (10) connected to the terminal element (9) is arranged in the vicinity of the second contact point (7), such that the solder (12) connects the component (10) to the second contact point (7).

2. Method according to Claim 1, a gap width of the annular gap (11) being dimensioned such that the solder (12) is moved by capillary action from the first (5) to the second contact point (7).

3. Method according to one of the preceding claims, a layer produced from solder (8) being applied to the first (5) and/or the second contact point (7) before the production of the soldered joint.

4. Method according to one of the preceding claims, at least one further opening (13) connecting the first (5) to the second contact point (7) being provided.

5. Method according to one of the preceding claims, the diameter of the further opening (13) being dimensioned such that the solder (12) is moved by capillary action from the first (5) to the second contact point (7).

6. Method according to one of the preceding claims, the further opening (13) being provided in the edge region of the contact points (5, 7).

7. Circuit with a soldered joint produced according to one of Claims 1 to 6, of a terminal element (9) with a contact point (5, 7) provided on the circuit board (1) comprising the following features:
- a first contact point (5) on the lower face of the circuit board (1) and a second contact point (7) in opposing arrangement on the upper face of the circuit board (1),
- a terminal element (9) which is passed through an opening (6) penetrating the first (5) and the second contact point (7), so that the free end of the terminal element (9) projects beyond a plane described by the first contact point (5) and an annular gap (11) is formed between the wall of the opening (6) and the terminal element (9),
- the soldered joint between the first (5) and the second contact point (7) and the terminal element (9), being formed by applying molten solder (12) onto the first contact point (5) and the free end of the terminal element (9) so that the solder (12) penetrates into the annular gap (11) and flows along the terminal element (9) to the second contact point (7),
**characterised in that**
a component (10) connected to the terminal element (9) is arranged in the vicinity of the second contact point (7), such that the solder (12) connects the component (10) to the second contact point (7).

## Revendications

1. Procédé pour réaliser une liaison brasée d'un élément de raccordement (9) avec un emplacement de contact (5, 7) prévu sur une platine (1), comprenant les étapes suivantes :
- on prévoit un premier emplacement de contact (5) sur la face inférieure de la platine (1) et un second emplacement de contact (7) dans un agencement opposé sur la face supérieure de la platine (1),
- on fait passer un élément de raccordement (9) à travers une traversée (6) qui passe à travers le premier (5) et le second emplacement de contact (7), de sorte que l'extrémité libre de l'élément de raccordement (9) dépasse au-delà d'un plan défini par le premier emplacement de contact (5) et qu'il se forme une fente annulaire (11) entre la paroi de la traversée (6) et l'élément de raccordement (9), et
- on applique un produit de brasage (12) à l'état liquide fondu sur le premier emplacement de contact (5) et l'extrémité libre de l'élément de raccordement (9), de sorte que le produit de brasage (12) pénètre dans la fente annulaire (11) et s'écoule le long de l'élément de raccordement (9) vers le second emplacement de contact (7) et qu'il se forme une liaison brasée entre le premier (5) et le second emplacement de contact (7) et l'élément de raccordement (9),
**caractérisé en ce qu'**on agence un composant (10) relié à l'élément de raccordement (9) au voisinage du second emplacement de contact (7) de telle sorte que le produit de brasage (12) relie le composant (10) au second emplacement de contact (7).

2. Procédé selon la revendication 1, dans lequel la largeur de la fente annulaire (11) est dimensionnée de telle façon que le produit de brasage (12) est déplacé par des forces capillaires du premier (5) au second emplacement de contact (7).

3. Procédé selon l'une des revendications précédentes, dans lequel avant la réalisation de la liaison brasée on applique sur le premier (5) et/ou sur le second emplacement de contact (7) une couche produite en produit de brasage (8).

4. Procédé selon l'une des revendications précédentes, dans lequel il est prévu au moins une autre traversée (13) qui relie le premier (5) au second emplacement de contact (7).

5. Procédé selon l'une des revendications précédentes, dans lequel le diamètre de l'autre traversée (13) est dimensionné de telle façon que le produit de brasage (12) est déplacé par des forces capillaires du premier (5) au second emplacement de contact (7).

6. Procédé selon l'une des revendications précédentes, dans lequel l'autre traversée (13) est prévue dans la zone de bordure des emplacements de contact (5, 7).

7. Circuit comprenant une liaison brasée réalisée selon les revendications 1 à 6, d'un élément de raccordement (9) avec un emplacement de contact (5, 7) prévu sur la platine (1), présentant les caractéristiques suivantes :
- un premier emplacement de contact (5) sur la face inférieure de la platine (1) et un second emplacement de contact (7) dans un agencement opposé sur la face supérieure de la platine (1),
- un élément de raccordement (9) qui est passé à travers une traversée (6) qui passe à travers le premier (5) et le second emplacement de contact (7), de sorte que l'extrémité libre de l'élément de raccordement (9) dépasse au-delà d'un plan défini par le premier emplacement de contact (5) et qu'il se forme une fente annulaire (11) entre la paroi de la traversée (6) et l'élément de raccordement (9), et dans lequel
- la liaison brasée entre le premier (5) et le second emplacement de contact (7) et l'élément de raccordement (9) est formée par application d'un produit de brasage (12) à l'état liquide fondu sur le premier emplacement de contact (5) et l'extrémité libre de l'élément de raccordement (9), de sorte que le produit de brasage (12) pénètre dans la fente annulaire (11) et s'écoule le long de l'élément de raccordement (9) vers le second emplacement de contact (7),
**caractérisé en ce qu'**un composant (10) relié à l'élément de raccordement (9) est agencé au voisinage du second emplacement de contact (7) de telle sorte que le produit de brasage (12) relie le composant (10) au second emplacement de contact (7).
